# EUROPEAN PATENT APPLICATION

(11) **EP 4 697 888 A1**
(43) Date of publication of application: **18.02.2026**
(21) Application number: 25189877.1
(22) Date of filing: 16.07.2025
(51) Int. Cl.: H10D 30/66, H10D 62/00, H10D 62/10, H10D 62/17, H10D 62/832, H10P 30/22

(54) **POWER DEVICE AND MANUFACTURING METHOD THEREOF**

(30) Priority: 15.08.2024 TW 113130755
(71) Applicant: Avanzati Semiconductor Pte. Ltd, 048693 Singapore (SG)
(72) Inventor: LO VERDE, Domenico, 048693 Singapore (SG); CESARE, Ronsisvalle, 048693 Singapore (SG); HSH, Huang-Pin, 048693 Singapore (SG); HUANG, Tzu-Hao, 048693 Singapore (SG); HSIEH, Sung-Ying, 048693 Singapore (SG)
(74) Representative: Patentanwaltskanzlei WILHELM & BECK

(57) **Abstract**

The present invention involves a power device and a manufacturing method thereof. The method comprising steps of providing a semiconductor substrate (100), growing an epitaxial layer (101) on the semiconductor substrate (100), forming an insulating layer (102-1) on the epitaxial layer (101), forming a metal mask layer (HMSK) on the insulating layer (102-1), and performing an ion implantation process from above the metal mask layer (HMSK) on the epitaxial layer (101). The metal mask layer (HMSK) includes an ion implantation blocking region and an ion implantation penetration region.

## Description

This application claims the priority of Taiwan Application Application No. 113130755, filed on August 15, 2024.

The present disclosure relates to a power device and a method for manufacturing the same. More particularly, the present disclosure pertains to a power device with low drain-source on-resistance (RDS(on)), high breakdown voltage, and high current capability, as well as a method for manufacturing such a device.

After the release of the first wafers in 1991, silicon carbide (SiC) evolved fairly slowly, with the launch of the first full SiC commercial MOSFET only twenty years later. In the end, it was Tesla and its 400V inverter that propelled silicon carbide materials to the forefront of development in 2018. Since then, there has been increasing interest in SiC-based products that feature high power density, efficiency, and high-temperature performance to the delight of the automotive market segment looking for a solution to fulfill the requirements of under-the-hood applications. Over the last 5 years, technological innovations on SiC power mosfets have followed innovation after innovation, all with the aim of upgrading the performance of the devices exponentially and making them unique in their use. Due to the fact that the cost of SiC wafers on the market today is very expensive, the need arises to reduce the size of the dies to obtain a lower cost of the final device. In this view, an ever-increasing number of companies are interested in innovation to obtain advantages on the costs and performance of the devices.

Currently, the most advanced SiC MOSFET technology in the power semiconductor market is the technology called CoolSiC. That technology is a hybrid superjunction (SJ) patented technology from Infineon. This technology is a technology that uses a very small cell pitch of the order of 1-3 µm and at the moment it is the technology that occupies approximately 10-20% of the SiC MOSFET market. More specifically, this technology is the Micro Trench CoolSiC technology Gen.2. The Micro Trench CoolSiC offers notable advantages and is regarded as a cutting-edge technology. In fact, with the support of simulations carried out with extremely precise simulators, it was possible to understand the main important parameters for increasing the current density per unit area and improving the overall performance of the device. In practice, due to an effect generated by the channel structure (inversion channel) delegated to the current conduction, the clean defects-free channel crystalline structure will allow the electrons to have high levels of mobility. This will minimize the channel resistance and will reduce the total device RDS(on) while increasing the current density per unit area.

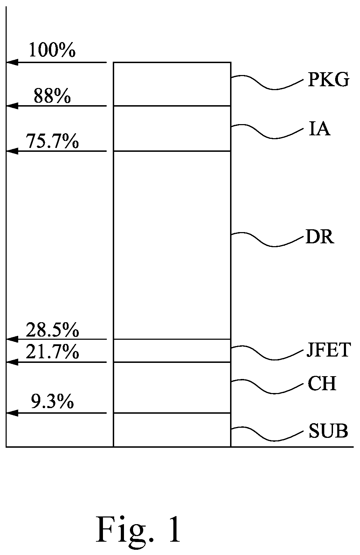

Referring to Fig. 1, which is a schematic diagram showing the contribution of various parts of a conventional SiC MOSFET high voltage wafer to RDS(on), wherein the vertical axis represents the cumulative percentage of the resistance value of a part to RDS(on). The parts listed in Fig. 1 include a packaging part (indicated by "PKG" in the figure), an inactive area (indicated by "IA" in the figure), a dice drift region (indicated by "DR" in the figure), a junction part (indicated by "JFET" in the figure), a channel part (indicated by "CH" in the figure), and a substrate part (indicated by "SUB" in the figure). One of the main contributors is the dice drift region (DR). It is evident that all the current research and development has made great progress in the resistance value of the channel part and increased the channel mobility to acceptable levels, and the contribution to RDS(on) has been significantly reduced. The drift layer level still remains one of the big high RDS(on) contributors that for dies in high voltage (>400V) is representing >40-50% of total RDS(on). This principle applies not only to SiC MOSFET, but also to the silicon MOSFET in the traditional high-voltage technologies.

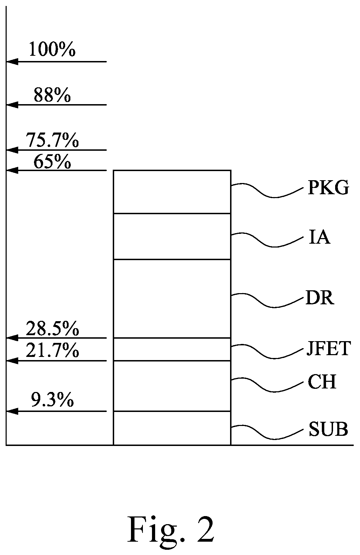

Therefore, in view of the deficiencies in the prior art, the applicants of the present application developed the present invention "POWER DEVICE AND MANUFACTURING METHOD THEREOF" to overcome the disadvantages of conventional technologies. The descriptions of the present invention are as follows:
As mentioned above, the main reason for high RDS(on) in standard Dmos Power MOSFET is the high contribution of the drift region, which can be improved by the implementation of the super junction technology. Originally proposed by Shozo Shirota and Shigeo Kaneda at Osaka University in 1978, this technology is to create a deep low-doped P-pillar region below the P-body region. This P-doped silicon pillar had the function to make a balancing charge between the P-pillar and the drift layer region. This balancing effect will temporarily reduce the drift layer doping concentration and allow the structure to sustain higher voltage without reducing the real drift layer concentration. That is, this low-doped P-pillar region can balance the N-type doping concentration in the adjacent drift region, so that the N-type doping concentration in the drift region is temporarily reduced when the device is turned off. Compared with the traditional structure, the reduced N-type concentration will enable the drift region to withstand a higher breakdown voltage when the device is turned off, and return to normal concentration when the device is turned on, which facilitates a lower RDS(on). In contrast to the conventional structure, it is not necessary to intentionally reduce the N-type doping concentration of the drift region during device manufacturing in order to increase the breakdown voltage, which ultimately results in an increase in RDS(on). On average, the RDS(on) of the new structure is reduced by about 30% to 40%. As shown in Fig. 2, after adopting the new structure, the contribution of the drift layer to RDS(on) has significantly decreased.

Although super junction technology is mature and widely used in silicon power devices, SiC is a material completely different from silicon. Therefore, different techniques must be used to form a super junction structure using SiC. When making P-pillar regions with silicon materials, the material to be doped can be slowly introduced by thermal diffusion through a high-temperature process, or implanted using an ion implanter. In contrast, due to the material properties of SiC, it is almost impossible to introduce dopants by thermal diffusion, and dopants can only be implanted by forced injection using an ion implanter. In order to realize the super junction P-pillar region structure, multiple implantations with different energies are required for SiC, and the maximum implant energy range needs to reach 0.5 MeV to 12 MeV. Apparently, there are many process problems to be overcome in such high-energy processing, such as the selection of mask materials during selective implantation. Specific structures and processes can achieve such high-energy processing. This disclosure provides a detailed explanation of how to build a power MOSFET in SJ technology.

Due to its crystalline structure, SiC is not suitable for thermal diffusion doping. Instead, dopants are introduced into SiC exclusively through high-energy ion implantation. To form the deep P-type pillars for an SJ structure in SiC, multiple ion implantations at varying energies, ranging from 0.5 MeV to 12 MeV, are required. This high-energy process introduces several technical challenges, including the need for specialized implantation masks. This disclosure provides a detailed explanation of the methods to fabricate a power MOSFET using SJ technology and SiC material.

In one aspect, the present invention provides a method for manufacturing a semiconductor device for forming a super junction (SJ) structure on a silicon carbide substrate. The method includes the following steps. A heavily doped semiconductor substrate is provided. An epitaxial layer is then grown on the heavily doped semiconductor substrate. A first insulating layer is deposited on the epitaxial layer, followed by the deposition of a metal seed layer on the first insulating layer. A photoresist layer is deposited on the metal seed layer. The photoresist layer includes a first portion and a second portion. The first portion of the photoresist layer is removed, while the second portion is left on the metal seed layer. A metal mask layer is formed on the metal seed layer by using either an electroplating process or a chemical coating process. After the metal mask layer is formed, the remaining second portion of the photoresist layer is removed. A first ion implantation of P-type dopants is then performed on the epitaxial layer. As a result of the first ion implantation, the epitaxial layer comprises a low-doped first carrier region and a second carrier region. The low-doped first carrier region includes a first epitaxial region and a second epitaxial region, beyond coverage by the metal mask layer. The second carrier region is indirectly covered by the metal mask layer. That is, the second carrier region is located beneath the area covered by the metal mask layer.

In another aspect, the present invention provides a method for manufacturing a semiconductor device. The method includes the following steps. A semiconductor substrate is provided. An epitaxial layer is grown on the semiconductor substrate. An insulating layer is then formed on the epitaxial layer. A metal mask layer is formed on the insulating layer. The metal mask layer includes an ion implantation blocking region and an ion implantation penetration region. After the metal mask layer is formed, an ion implantation process is performed from above the metal mask layer onto the epitaxial layer.

In another aspect, the present invention provides a super junction semiconductor structure. The super junction semiconductor structure includes a silicon carbide semiconductor substrate, a silicon carbide epitaxial layer grown on the silicon carbide semiconductor substrate, and a transistor. The epitaxial layer comprises a low-doped region that is formed by performing an ion implantation process on the epitaxial layer. The low-doped region includes a first depth epitaxial layer region and a second depth epitaxial layer region. The transistor comprises a body and a source. The low-doped region is connected to the body. The source is disposed over the low-doped region.

The embodiments and advantages of the present invention will become more readily apparent to those ordinarily skilled in the art after reviewing the following detailed descriptions and accompanying drawings.
Fig. 1 is a schematic diagram showing the contribution of various parts of a conventional SiC MOSFET device to RDS(on).
Fig. 3 to Fig. 10 are schematic diagrams showing a manufacturing process of a semiconductor device according to a preferred embodiment of the present disclosure.
Fig. 11 to Fig. 16 are schematic diagrams showing a manufacturing process of bodies of a transistor according to a preferred embodiment of the present disclosure.
Fig. 17 to Fig. 19 are schematic diagrams showing a manufacturing process of a second carrier region of the transistor according to a preferred embodiment of the present disclosure.
Fig. 20 to Fig. 26 are schematic diagrams showing a manufacturing process of a working channel and peripheral bodies of the transistor according to a preferred embodiment of the present disclosure.
Fig. 27 is a schematic diagram showing the result of manufacturing an edge terminal of the transistor according to a preferred embodiment of the present disclosure.
Fig. 28 is a schematic diagram showing the result of forming a barrier layer (a graphite layer) by thermal conversion during annealing according to a preferred embodiment of the present disclosure.
Fig. 29 is a schematic diagram showing the result of removing the barrier layer according to a preferred embodiment of the present disclosure.
Fig. 30 is a schematic diagram showing the result of manufacturing a gate dielectric layer of the transistor according to a preferred embodiment of the present disclosure.
Fig. 31 is a schematic diagram showing the result of depositing a polysilicon layer according to a preferred embodiment of the present disclosure.
Fig. 32 is a schematic diagram showing the result of depositing a top metal layer according to a preferred embodiment of the present disclosure.
Fig. 33 is a schematic diagram showing the result of depositing a protective layer according to a preferred embodiment of the present disclosure.
Fig. 34 is a schematic diagram showing the result of depositing metal contact pads on the back side of the wafer (referring to Fig. 33) according to a preferred embodiment of the present disclosure.

The present invention will now be described more specifically with reference to the following embodiments.

Unless otherwise limited or described in a specific example, the following definitions apply to terms used throughout this specification.

The term "comprising" or "including" as used herein means that in addition to the described components, steps, and/or elements, the presence of one or more other components, steps, and/or elements is not excluded.

The term "about" as used herein means there is a close or allowable error range to prevent the present invention from being limited to the exact or absolute numerical values disclosed. The term "a" used herein means that the object of the article is one or more than one.

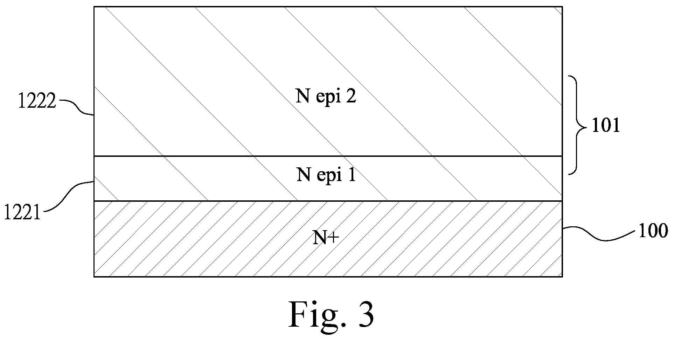

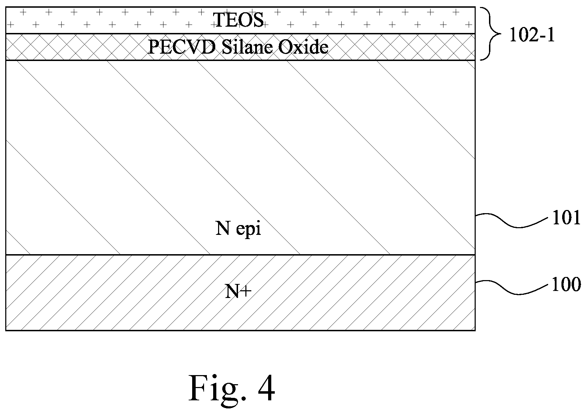

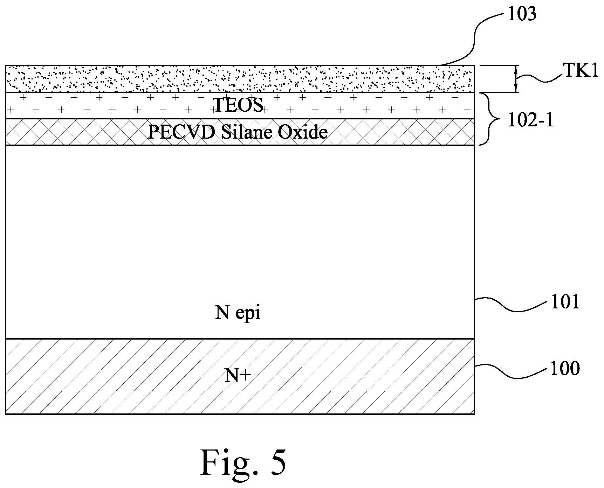

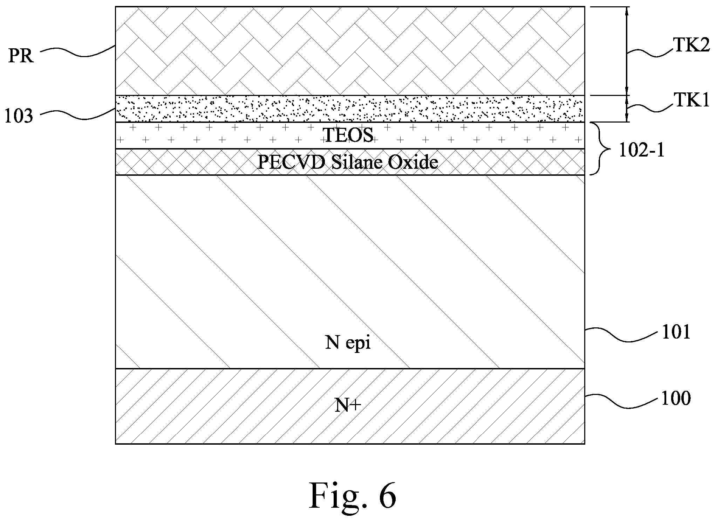

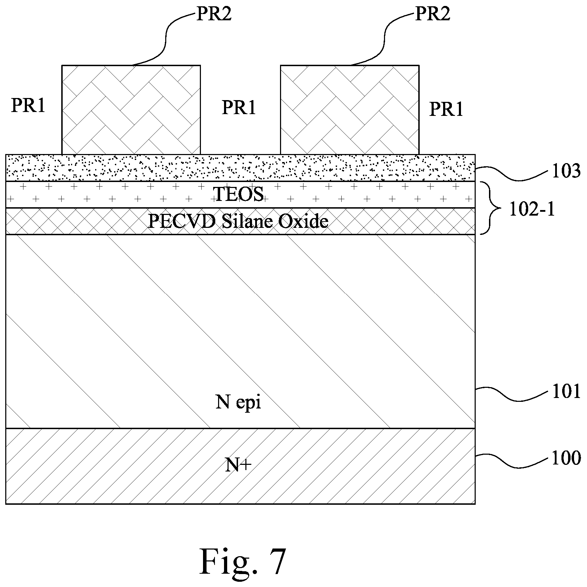

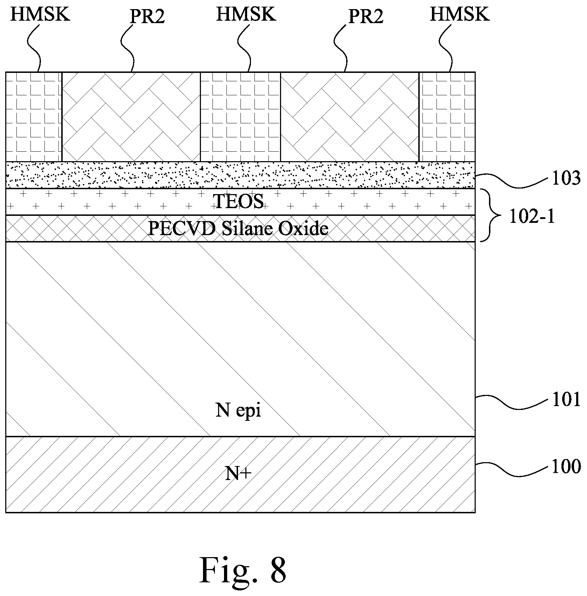

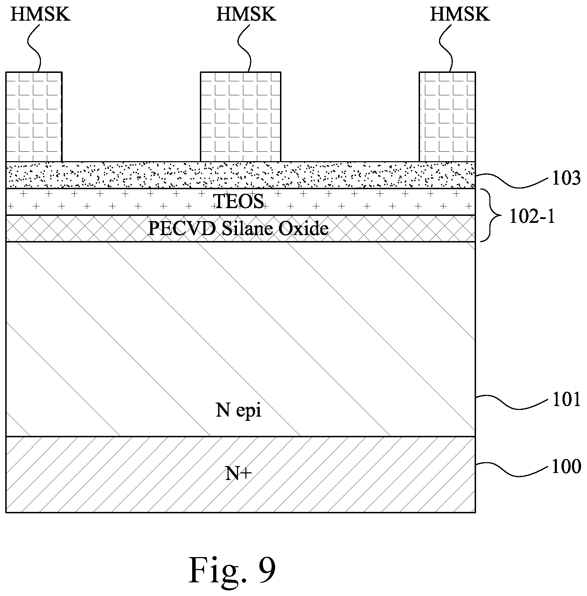

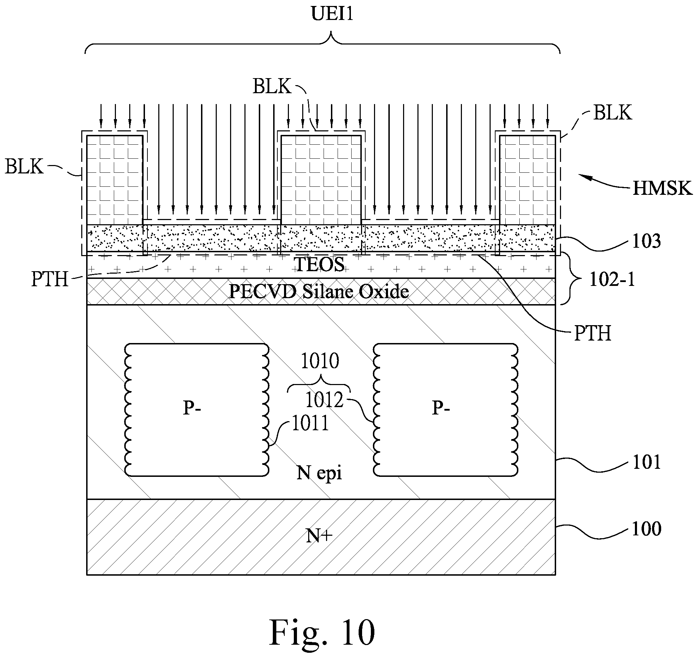

Please refer to Fig. 3 to Fig. 10, which are schematic diagrams showing a method for manufacturing a semiconductor device according to a preferred embodiment of the present disclosure. The method comprises the following steps. Please refer to Fig. 3, a heavily doped semiconductor substrate 100 is provided, and an epitaxial layer 101 is grown on the heavily doped semiconductor substrate 100. The heavily doped semiconductor substrate may have a c-axis orientation. As shown in Fig. 4, a first insulating layer 102-1 is deposited on the epitaxial layer 101. The first insulating layer 102-1 may have a single-layer structure or a multi-layer structure. As shown in Fig. 5, a metal seed layer 103 with a first thickness TK1 is deposited on the first insulating layer 102-1. As shown in Fig. 6, a photoresist layer PR with a second thickness TK2 is deposited on the metal seed layer 103, wherein the photoresist layer PR includes a first portion PR1 and a second portion PR2. As shown in Fig. 7, the first portion PR1 of the photoresist layer PR is removed using a first photolithographic process, and the second portion PR2 of the photoresist layer PR is left on the metal seed layer 103. As shown in Fig. 8, a metal mask layer HMSK with the second thickness TK2 is formed on the metal seed layer 103 by using an electroplating process or a chemical coating process, wherein the second thickness TK2 is greater than the first thickness TK1. As shown in Fig. 9, the second portion PR2 of the photoresist layer PR is removed, and portions of the metal seed layer 103 are exposed between the metal mask layer HMSK. As shown in Fig. 10, performing a first ion implantation UEI1 on a first epitaxial region 1011 and a second epitaxial region 1012 of the epitaxial layer 101 to form a low-doped first carrier region 1010 with a low doping concentration, so that the epitaxial layer 101 now comprises a low-doped first carrier region 1010 and not covered or protected by the metal mask layer HMSK, and a second carrier region. The second carrier region may be defined as a region outside the low-doped first carrier region 1010 in the epitaxial layer 101, or a region indirectly covered and protected by the metal mask layer. The first ion implantation is performed a plurality of times at varying energy levels to achieve implantation depths ranging from 0.5 µm to 50 µm, and the energy intensity thereof is in a mega-electronvolt (MeV) range.

In Fig. 3 to Fig. 10, a special process is provided for manufacturing a semiconductor having a super junction structure using SiC-based materials. Because the lattice arrangement of the SiC material is more compact than that of materials generally used in the silicon-based substrate, a very high energy is required to perform the ion implantation on the SiC material substrate, especially in the deep region of the SiC material substrate. The commonly used photoresist mask cannot block the ion implantation with a very high-energy, so it is required to use a "hard mask" to block the ion implantation. Very thick insulators or nitrides may be able to block the ion implantation with a very high-energy, but they are difficult to be removed afterwards, and such materials typically have high internal stress, which can cause wafer warpage if the layer is too thick. Therefore, metal is a more feasible option, as it provides sufficient strength with lower stress. Since thick metal layers are relatively expensive, the present disclosure adopts an electroplating or electroless (chemical plating) method to deposit a thick metal layer only on the regions where ion implantation needs to be blocked. In addition, the thicker metal mask layer HMSK can be used as an ion implantation blocking region BLK, and the thinner metal seed layer 103 can be used as an ion implantation penetration region PTH.

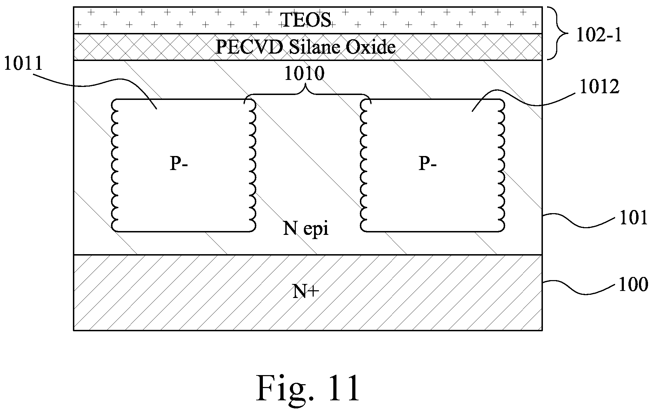

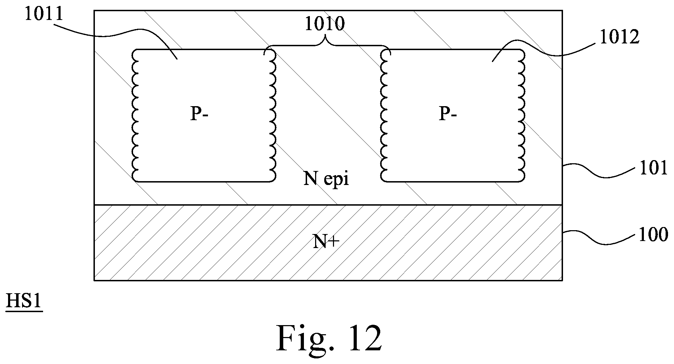

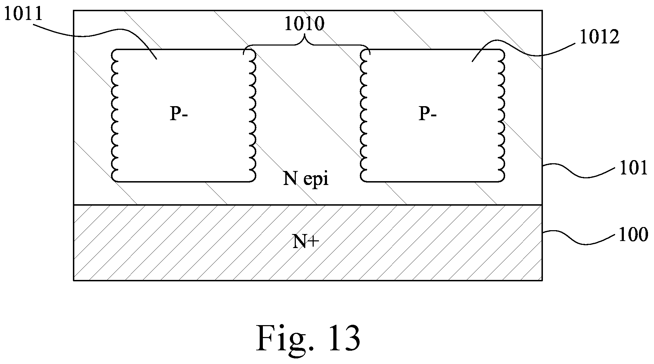

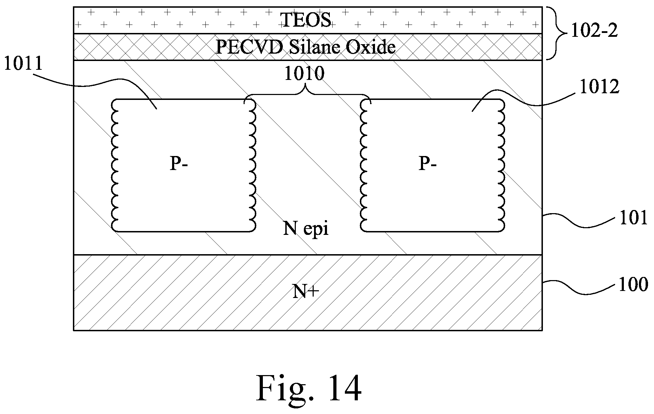

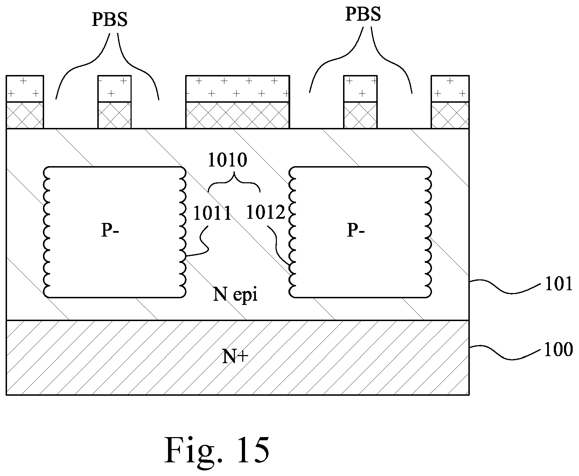

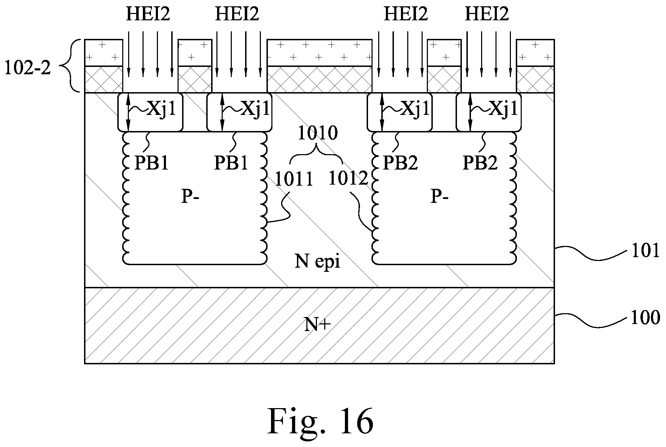

Please refer to Fig. 11 to Fig. 16, which are schematic diagrams showing the process to manufacture bodies PB1 and PB2 of the transistor 10 (as shown in Fig. 40) according to a preferred embodiment of the present disclosure. In any embodiment of the present disclosure, the manufacturing method further includes the following steps of manufacturing bodies. As shown in Fig. 11, the metal mask layer HMSK and the metal seed layer 103 are removed. As shown in Fig. 12, the first insulating layer 102-1 is removed so as to form a first semi-finished product HS1. The first semi-finished product HS 1 includes the heavily doped semiconductor substrate 100 and the epitaxial layer 101 (which includes the low-doped first carrier region 1010 and the second carrier region in the epitaxial layer 101). As shown in Fig. 13, the first semi-finished product HS1 is thermally annealed at a temperature greater than 1000 °C. As shown in Fig. 14, a second insulating layer 102-2 is deposited on the epitaxial layer 101 of the first semi-finished product HS1. The second insulating layer 102-2 may include a silicon oxide precursor layer and a silane oxide material layer. The silicon oxide precursor layer may be, for example, tetra ethoxy silane (TEOS). As shown in Fig. 15, the second insulating layer 102-2 above the low-doped first carrier region 1010 is etched to form body structures PBS. As shown in Fig. 16, a second ion implantation HEI2 is performed on the regions between the body structures PBS and the first epitaxial region 1011, and between the body structures PBS and the second epitaxial region 1012 to respectively form first bodies PB1 and second bodies PB2 doped with the first carriers in the epitaxial layer, wherein the first bodies PB1 and the second bodies PB2 each have a first carrier doping depth Xj1 in a micrometer level. The second ion implantation is performed under a substrate temperature of 100 °C to 1000 °C at an energy level in a range of 5 keV to 500 keV, and a body carrier concentration of the first bodies PB1 and the second bodies PB2 is about 1e5 to 1e20 carriers/cm². The first carriers may be P-type carriers, such as aluminum (Al) or boron (B), and the second carriers may be N-type carriers.

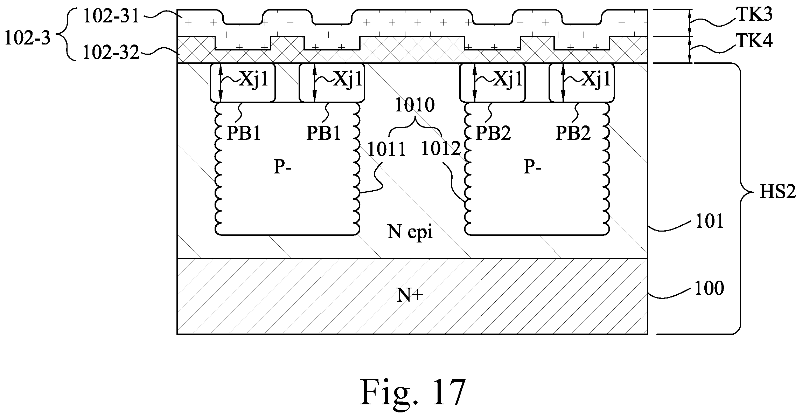

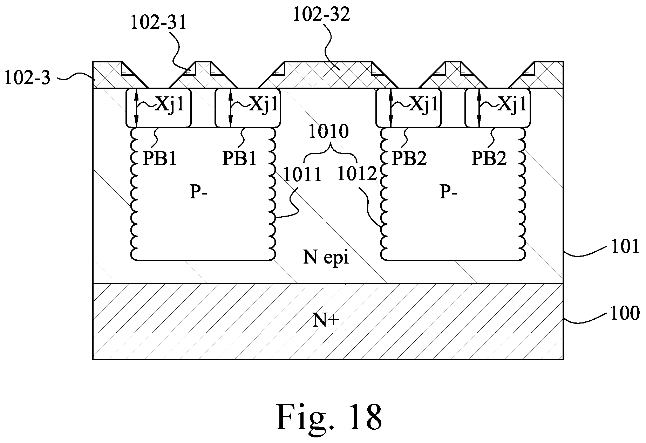

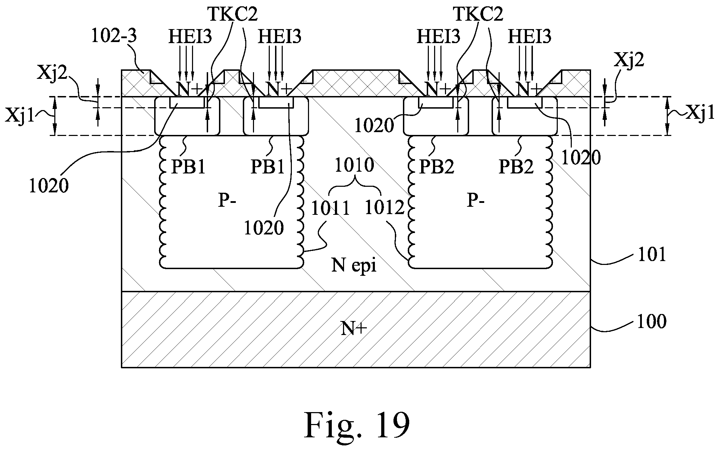

Please refer to Fig. 17 to Fig. 19, which are schematic diagrams showing the manufacturing process of the heavily doped second carrier region 1020 (in Fig. 19) of the transistor 10 according to a preferred embodiment of the present disclosure. In any embodiment of the present disclosure, the manufacturing method may further include the following steps for manufacturing a second carrier region. The second insulating layer 102-2 is removed to form a second semi-finished product HS2. As shown in Fig. 17, a third insulating layer 102-3 is deposited on the epitaxial layer 101, the first bodies PB1, and the second bodies PB2 of the second semi-finished product HS2. The third insulating layer 102-3 includes a third silicon oxide precursor layer 102-31 and a third silane oxide material layer 102-32. A third layer thickness TK3 of the third silicon oxide precursor layer 102-31 and a fourth layer thickness TK4 of the third silane oxide material layer 102-32 are nanometer-scale thicknesses. The third silicon oxide precursor layer 102-31 may be, for example, tetra ethoxy silane (TEOS). As shown in Fig. 18, the third insulating layer 102-3 on the first bodies PB1 and the second bodies PB2 is etched until at least portions of the first bodies PB1 and the second bodies PB2 are exposed. The exposed portions are surfaces of silicon carbide materials. As shown in Fig. 19, under the condition that the temperature of the heavily doped semiconductor substrate 100 is 100-1000 °C, a third ion implantation HEI3 is used to dope the second carriers N+ into the first bodies PB1 and the second bodies PB2 to form a heavily doped second carrier region 1020. The heavily doped second carrier region 1020 has a second carrier layer thickness TKC2 in the micrometer level. The heavily doped second carrier region 1020 has a second carrier doping depth Xj2 in the micrometer level. The implantation energy used in the third ion implantation HEI3 ranges from 5k to 500k electron volts.

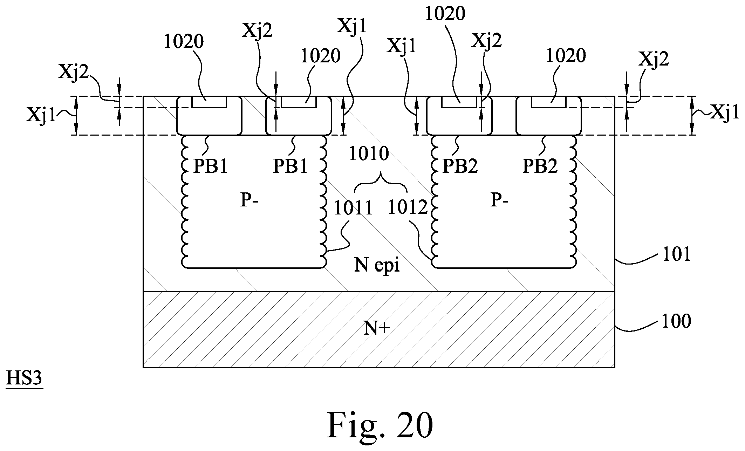

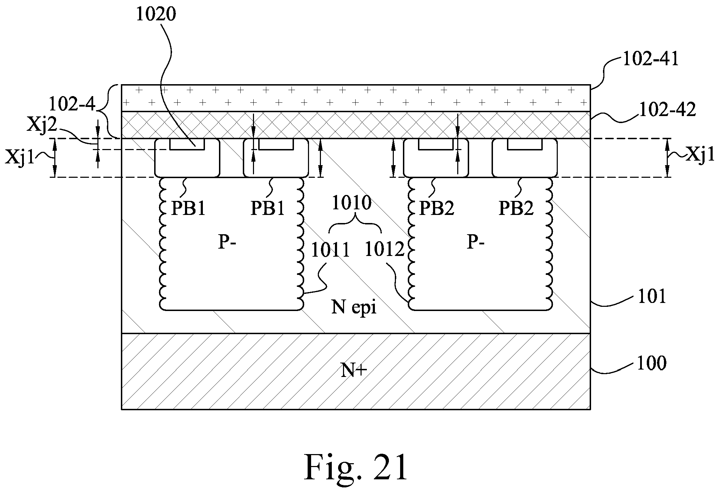

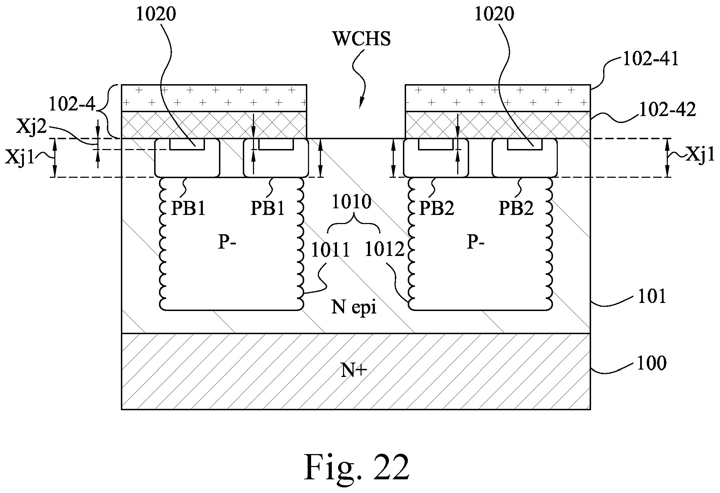

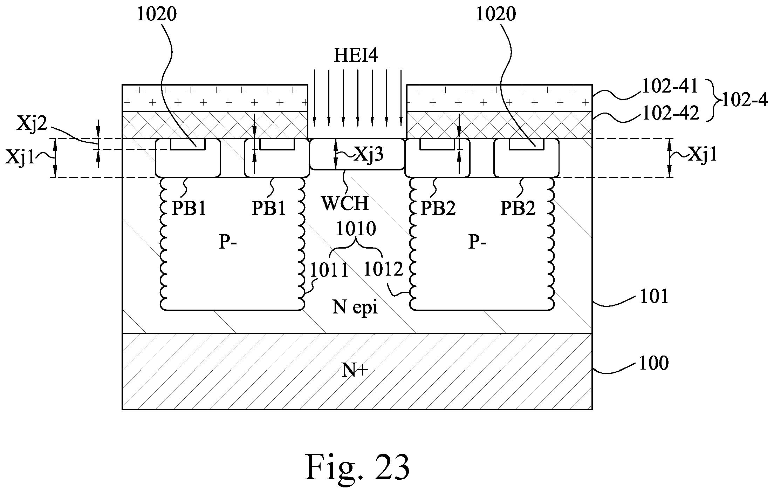

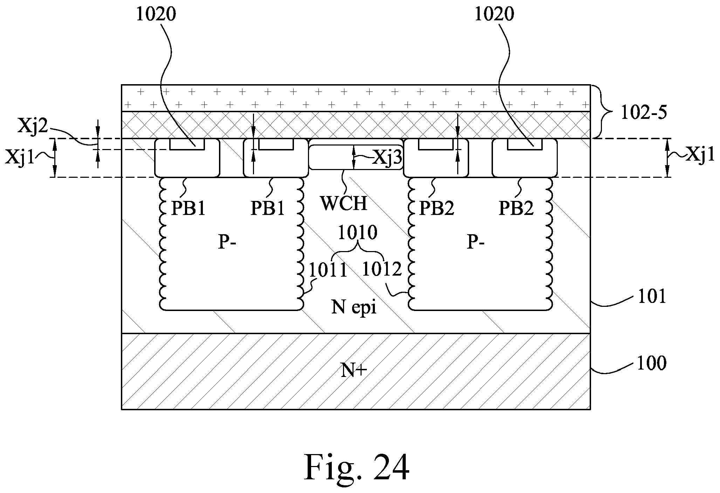

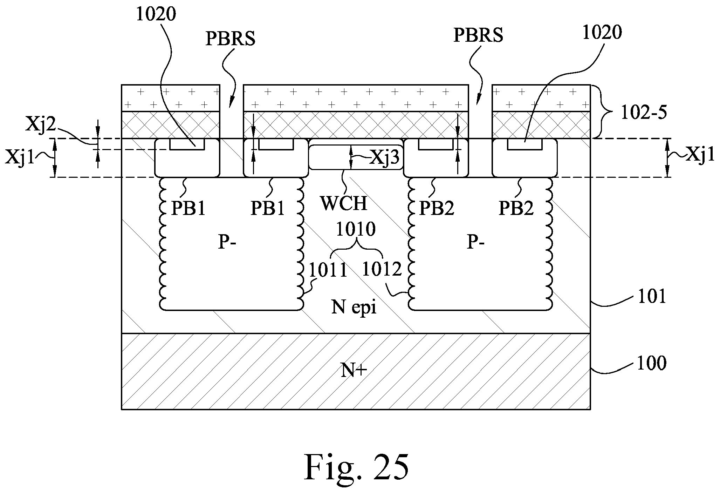

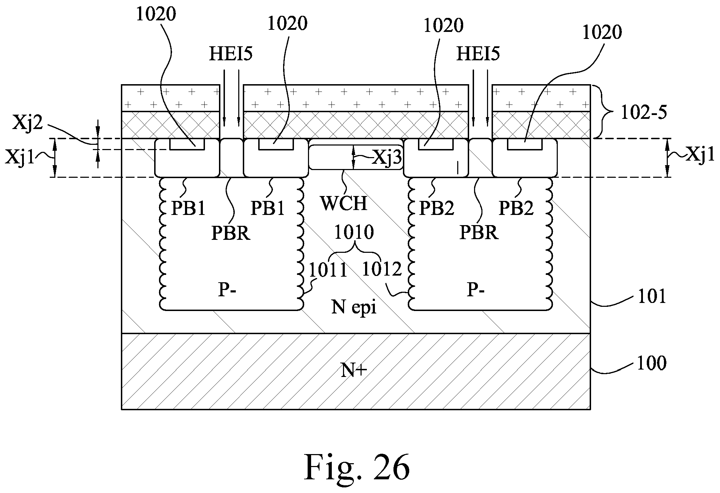

Please refer to Fig. 20 to Fig. 26, which are schematic diagrams showing the manufacturing process of a working channel WCH (in Fig. 23) and peripheral bodies PBR (in Fig. 26) of the transistor 10 according to a preferred embodiment of the present disclosure. In any embodiment of the present disclosure, the manufacturing method may further include the following steps for manufacturing a working channel and peripheral bodies. As shown in Fig.20, the third insulating layer 102-3 is etched until the epitaxial layer 101 and the heavily doped second carrier region 1020 are exposed to form a third semi-finished product HS3. As shown in Fig. 21, a fourth insulating layer 102-4 is deposited on the epitaxial layer 101, the first bodies PB1, the second bodies PB2, and the heavily-doped second carrier region 1020 of the third semi-finished product HS3. The fourth insulating layer 102-4 includes a fourth silicon oxide precursor layer 102-41 and a fourth silane oxide material layer 102-42. The fourth silicon oxide precursor layer 102-41 and the fourth silane oxide material layer 102-42 each have a thickness in a nanometer level. As shown in Fig. 22, a working channel pattern structure WCHS is formed on the fourth insulating layer 102-4 by using a second photolithographic process. As shown in Fig. 23, a fourth ion implantation HEI4 is performed on the epitaxial layer 101 below the working channel pattern structure WCHS to form a working channel portion WCH. The working channel portion WCH has a doping depth Xj3 in a micrometer level. The implantation energy used in the fourth ion implantation HEI4 is in a range of 5k-500k electron volts. As shown in Fig. 24, the fourth insulating layer 102-4 is replaced by a fifth insulating layer 102-5. As shown in Fig. 25, peripheral body pattern structures PBRS are formed on the fifth insulating layer 102-5 by a third photolithographic process. As shown in Fig. 26, a fifth ion implantation HEI5 is performed on the epitaxial layer 101 below the peripheral body pattern structures PBRS to form heavily doped peripheral body pattern structures PBR, wherein a doping depth of the heavily doped peripheral body pattern structures PBR is similar to that of the first bodies PB1 and the second bodies PB2. The implantation energy range of the fifth ion implantation HEI5 is 5k-500k electron volts, and the implanted carriers may be, for example, aluminum Al, and the implanted carrier concentration is about 1e5-1e20 carriers/cm².

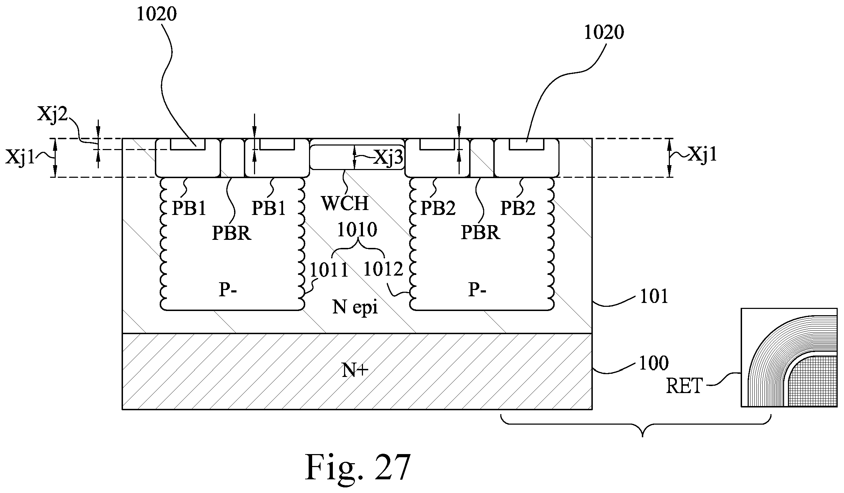

Please refer to Fig. 27, which is a schematic diagram showing the result of manufacturing an edge terminal RET of the transistor 10 according to a preferred embodiment of the present disclosure. In any embodiment of the present disclosure, as shown in Fig. 27, the edge terminal RET of the transistor 10 is manufactured by replacing the fifth insulating layer 105-2, and then performing a photolithographic and etching process to form the edge terminal RET.

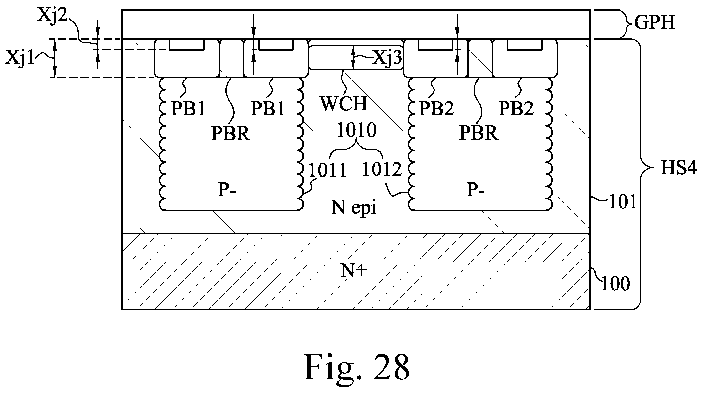

Please refer to Fig. 28, which is a schematic diagram showing the result of adding a barrier layer GPH during thermal annealing according to a preferred embodiment of the present disclosure. In any embodiment of the present disclosure, as shown in Fig. 28, the barrier layer is used to ensure that the materials are precipitated during annealing. This process can improve the surface conductivity of the SiC material semi-finished product HS4 after removing the barrier layer.

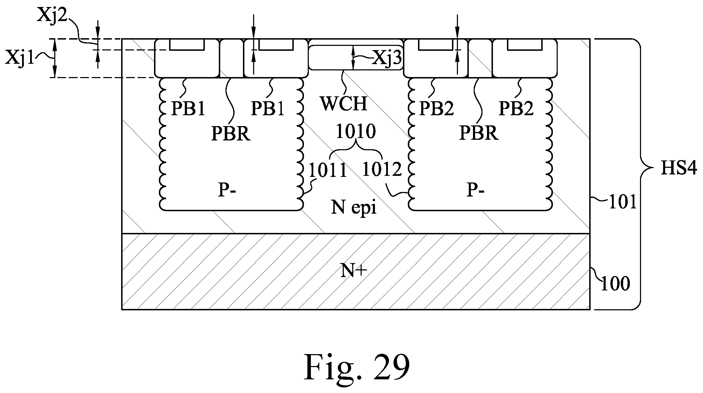

Please refer to Fig. 29, which is a schematic diagram showing the result of removing the barrier layer according to a preferred embodiment of the present disclosure. In any embodiment of the present disclosure, as shown in Fig. 29, the barrier layer may be removed in a dry etching apparatus using an etching gas that does not damage the surface of the SIC.

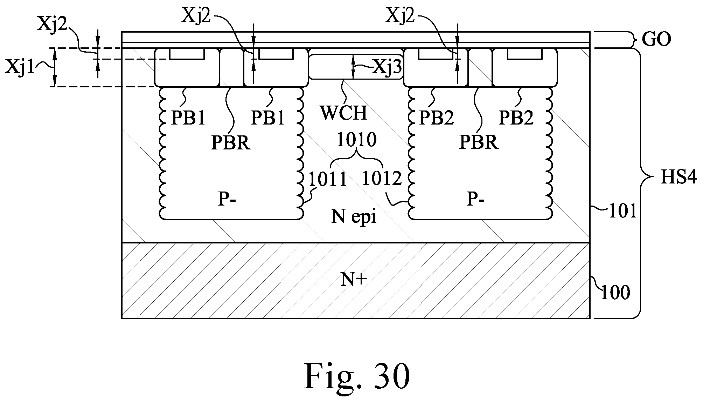

Please refer to Fig. 30, which is a schematic diagram showing the result of manufacturing the gate dielectric layer GO of the transistor 10 (shown in Fig. 40) according to a preferred embodiment of the present disclosure. In any embodiment of the present disclosure, as shown in Fig. 30 , an insulating layer 102-6 is formed on the SiC material semi-finished product HS4 at a high temperature to form a gate dielectric layer GO.

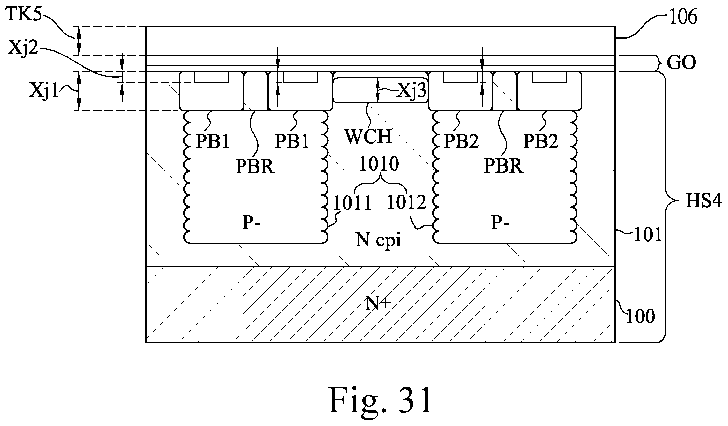

Please refer to Fig. 31, which is a schematic diagram showing the result of depositing a polysilicon layer according to a preferred embodiment of the present disclosure. A polysilicon layer 106 is deposited on the gate dielectric layer GO and has a thickness TK5 of about 4000 Å.

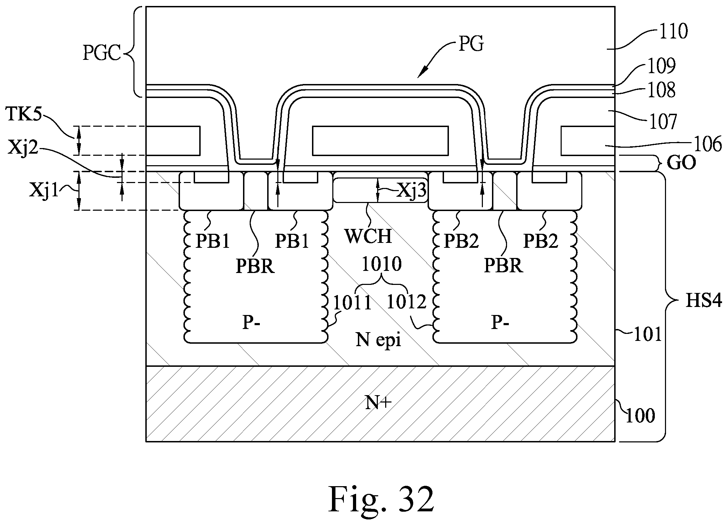

Please refer to Fig. 32, which is a schematic diagram showing the result of depositing top metal layers according to a preferred embodiment of the present disclosure. The top metal layers include a bonding layer 108, a bonding layer 109, and a top metal layer 110 .

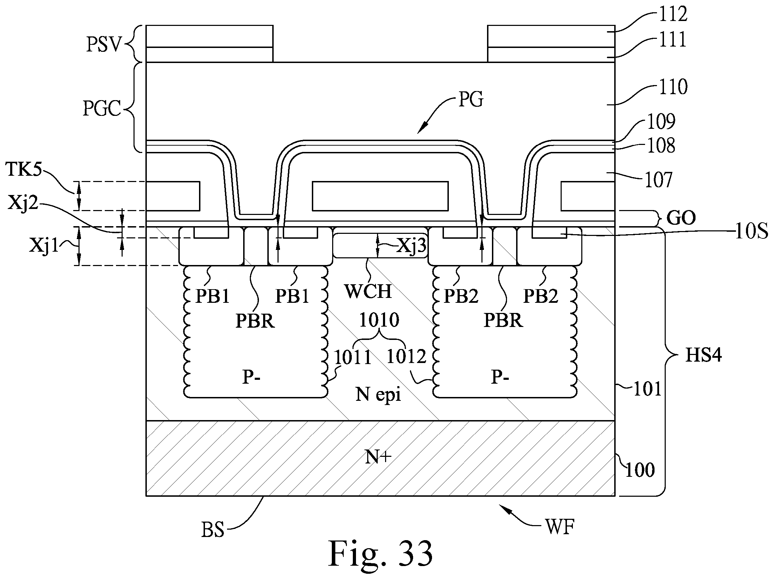

Please refer to Fig. 33, which is a schematic diagram showing the result of depositing a protective layer PSV according to a preferred embodiment of the present disclosure. In any embodiment of the present disclosure, the step of depositing the protection layer PSV includes the steps of depositing a PSV layer 111 on the top metal layer 110 and depositing a PSV layer 112 on the PSV layer 111.

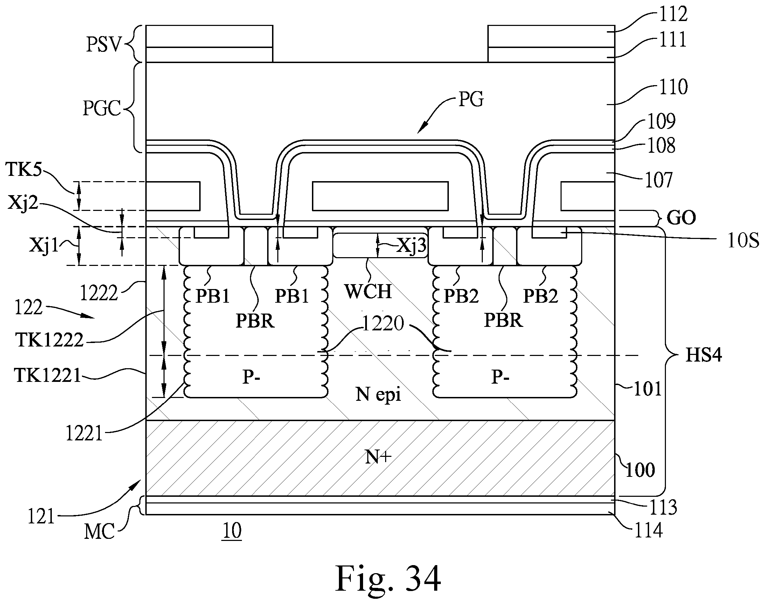

Please refer to Fig. 34, which is a schematic diagram showing the result of depositing metal contact pads MC on the back side BS of the wafer WF (referring to Fig. 33) according to a preferred embodiment of the present disclosure. First, a metal layer 113 is configured on the back side BS of the heavily doped semiconductor substrate 100 and then a thermal annealing is performed at a high temperature. Then, a metal layer 114 is deposited on the metal layer 113.

Fig. 34 shows a completed transistor 10 having a superjunction semiconductor structure. The superjunction semiconductor structure includes a silicon carbide semiconductor substrate 121 and a silicon carbide epitaxial layer 122. The silicon carbide epitaxial layer 122 is grown on the silicon carbide semiconductor substrate 121 and includes a low-doped region 1220. The low-doped region 1220 has a low-doping concentration and is formed by performing an ion implantation process on the silicon carbide epitaxial layer 122. The low-doped region 1220 is electrically connected to bodies PB of the transistor 10.

In any embodiment of the present disclosure, the superjunction semiconductor structure further includes two sources 10S of the transistor 10, a gate dielectric layer GO of the transistor 10, a junction field effect channel (JFET) WCH of the transistor 10, peripheral bodies PBR of the transistor 10, and a polysilicon gate PG. The gate dielectric layer GO is configured on the two sources 10S and the bodies PB, and is connected to the two sources 10S and the bodies PB. The junction field effect channel WCH is configured in the silicon carbide epitaxial layer 122 and among the low-doped region 1220, the bodies PB and the gate dielectric layer GO, and is connected to the silicon carbide epitaxial layer 122, the bodies PB, and the gate dielectric layer GO. The peripheral bodies PBR are connected to the bodies PB and the low doped region 1220 in the silicon carbide epitaxial layer 122. The polysilicon gate PG is disposed on the two sources 10S, the bodies PB, the junction field effect channel WCH, the silicon carbide epitaxial layer 122, and the gate dielectric layer GO, and is connected to the gate dielectric layer GO.

In any embodiment of the present disclosure, the bodies PB have heavily doped first carriers. The silicon carbide semiconductor substrate 121, the two sources 10S, and the junction field effect channel WCH have heavily doped second carriers. The first carriers are P-type carriers, such as holes, and the second carriers are N-type carriers, such as electrons. The silicon carbide semiconductor substrate 121 is a heavily doped semiconductor substrate, such as an N-type or a P-type heavily doped semiconductor substrate. The silicon carbide epitaxial layer 122 is an N-type or P-type silicon carbide epitaxial layer. The low doped region 1220 includes a first depth epitaxial layer portion 1221 and a second depth epitaxial layer portion 1222. The thickness TK1221 of the first depth epitaxial layer portion 1221 is smaller than the thickness TK1222 of the second depth epitaxial layer portion 1222.

## Claims

1. A method for manufacturing a semiconductor device, comprising:
providing a semiconductor substrate (100);
growing an epitaxial layer (101) on the semiconductor substrate (100);
forming an insulating layer (102-1) on the epitaxial layer (101);
forming a metal mask layer (HMSK) on the insulating layer (102-1), wherein the metal mask layer (HMSK) includes an ion implantation blocking region and an ion implantation penetration region; and
performing an ion implantation process from above the metal mask layer (HMSK) on the epitaxial layer (101).

2. The method of Claim **1,** wherein the metal mask layer (HMSK) comprises tungsten, and the semiconductor substrate (100) is a heavily doped semiconductor substrate (100).

3. The method of Claim 1, wherein the ion implantation penetration region has a first thickness (TK1), the ion implantation blocking region has a second thickness (TK2), and the second thickness (TK2) is greater than the first thickness (TK1).

4. The method of Claim 1, further comprising:
depositing a metal seed layer (103) having a first thickness (TK1) on the insulating layer (102-1);
depositing a photoresist layer (PR) having a second thickness (TK2) on the metal seed layer (103), wherein the photoresist layer (PR) includes a first portion (PR1) and a second portion (PR2);
removing the first portion (PR1) of the photoresist layer (PR) and leaving the second portion (PR2) of the photoresist layer (PR) on the metal seed layer (103);
forming the metal mask layer (HMSK) having the second thickness (TK2) on the metal seed layer (103) by using an electroplating process;
removing the second portion (PR2) of the photoresist layer (PR); and
performing the ion implantation process on the epitaxial layer (101) a plurality of times at varying energy levels to achieve implantation depths ranging from 0.5 µm to 50 µm to form a low-doped first carrier region (1010) including a first epitaxial region (1011) and a second epitaxial region (1012), wherein the energy levels are related to implantation depths for first carriers.

5. The method of Claim 4, wherein:
the low-doped first carrier region (1010) is a P-type carrier region; and
the insulating layer (102-1) has a single-layer structure or a multi-layer structure.

6. The method of Claim 4, further comprising:
removing the metal mask layer (HMSK), the metal seed layer (103) and the insulating layer (102-1) to form a first semi-finished product (HS1) comprising the heavily doped semiconductor substrate (100) and the epitaxial layer (101);
thermally annealing the first semi-finished product (HS1);
depositing a second insulating layer (102-2) on the epitaxial layer (101) of the first semi-finished product (HS1);
etching the second insulating layer (102-2) above the low-doped first carrier region (1010) to form a body structure (PBS); and
performing a second ion implantation on the body structure (PBS) above the first epitaxial region (1011) and the second epitaxial region (1012) to form a first body (PB1) and a second body (PB2) with a first carrier doping depth (Xj1) in a micrometer scale.

7. The method of Claim 6, further comprising:
removing the second insulating layer (102-2) to form a second semi-finished product (HS2);
depositing a third insulating layer (102-3) on the second semi-finished product (HS2);
etching the third insulating layer (102-3) above the first and second bodies (PB1, PB2); and
performing a third ion implantation of second carriers on the first and second bodies (PB1, PB2) to form a heavily doped second carrier region (1020) in the first and second bodies (PB1, PB2) in the epitaxial layer (101).

8. The method of Claim 7, further comprising:
etching the third insulating layer (102-3) remained on the epitaxial layer (101), thereby forming a third semi-finished product (HS3);
depositing a fourth insulating layer (102-4) on the epitaxial layer (101) of the third semi-finished product (HS3);
forming a working channel pattern structure (WCHS) on the fourth insulating layer (102-4);
performing a fourth ion implantation on the epitaxial layer (101) below the working channel pattern structure (WCHS) to form a working channel portion (WCH);
replacing the fourth insulating layer (102-4) with a fifth insulating layer (102-5);
forming a peripheral body pattern structure (PBRS) on the fifth insulating layer (102-5); and
performing a fifth ion implantation on the epitaxial layer (101) below the peripheral body pattern structure (PBRS) to form a heavily doped peripheral body pattern structure (PBR).

9. The method of Claim 8, wherein:
the epitaxial layer (101) is an N-type or a P-type epitaxial layer (101) and comprises a first depth epitaxial layer portion (1221) and a second depth epitaxial layer portion (1222);
either of the first depth epitaxial layer portion (1221) and the second depth epitaxial layer portion (1222) has a micrometer-scale thickness;
the second ion implantation and the third ion implantation are performed under a substrate temperature of 100°C to 1000°C at an energy level in a range of 5 keV to 500 keV, and the first body (PB1) and the second body (PB2) have an implanted carrier concentration in a range of 1e5 to 1e20 carriers /cm²;
the third insulating layer (102-3) comprises a third silicon oxide precursor layer (102-31) and a third silane oxide material layer (102-32); and
either of the third silicon oxide precursor layer (102-31) and the third silane oxide material layer (102-32) has a nanometer-scale thickness.

10. The method of Claim 8, wherein:
the ion implantation process is performed a plurality of times at varying energy levels in a mega-electronvolt (MeV) range;
the heavily doped second carrier region (1020) has a micrometer-scale thickness; and
either of the fourth ion implantation and the fifth ion implantation has an implantation energy in a range of 5 keV and 500 keV.

11. A super junction semiconductor structure, comprising:
a silicon carbide semiconductor substrate (121);
a silicon carbide epitaxial layer (122) grown on the silicon carbide semiconductor substrate (121) and comprising a low-doped region (1220) formed by performing an ion implantation process on the silicon carbide epitaxial layer (122), wherein the low-doped region (1220) comprises a first depth epitaxial layer region and a second depth epitaxial layer region; and
a transistor (10) comprising a body (PB) and a source (10S), wherein:
the low-doped region (1220) is connected to the body (PB); and
the source (10S) is disposed over the low-doped region (1220).

12. The super junction semiconductor structure of Claim 11, wherein the transistor (10) further comprises:
a gate dielectric layer (GO) disposed on and connected to the source (10S) and the body (PB);
a junction field effect channel (JFET) (WCH) disposed among and connected to the silicon carbide epitaxial layer (122), the body (PB), and the gate dielectric layer (GO);
a peripheral body connected to the body and the low-doped region (1220) of the silicon carbide epitaxial layer (122); and
a polysilicon gate (PG) disposed on the source (10S), the body (PB), the JFET (WCH), the silicon carbide epitaxial layer (122) and the gate dielectric layer (GO), and connected to the gate dielectric layer (GO).

13. The super junction semiconductor structure of Claim 12, wherein the body has heavily doped first carriers, and the silicon carbide semiconductor substrate (121), the source (10S), and the JFET (WCH) have heavily doped second carriers.

14. The super junction semiconductor structure of Claim 12, wherein:
the first carriers are P-type carriers, and the second carriers are N-type carriers;
the silicon carbide semiconductor substrate (121) is a heavily N-doped or P-doped semiconductor substrate (121); and
the heavily N-doped or P-doped semiconductor substrate (121) has a C-axis crystal orientation.

15. The super junction semiconductor structure of Claim 12, wherein:
the silicon carbide epitaxial layer (122) is an N-type or P-type silicon carbide epitaxial layer (122); and
either of the first depth epitaxial layer region and the second depth epitaxial layer region has a micrometer-scale thickness.
